(19) Europäisches Patentamt
European Patent Office
Office européen des brevets

(11) Veröffentlichungsnummer : **0 474 964 B1**

(12) **EUROPÄISCHE PATENTSCHRIFT**

(45) Veröffentlichungstag der Patentschrift :
**08.06.94 Patentblatt 94/23**

(51) Int. Cl.$^5$ : **C23C 14/56, C23C 14/24**

(21) Anmeldenummer : **91106764.3**

(22) Anmeldetag : **26.04.91**

(54) **Vorrichtung zur laufenden Beschichtung von bandförmigen Substraten.**

(30) Priorität : **27.08.90 DE 4027034**

(43) Veröffentlichungstag der Anmeldung :
**18.03.92 Patentblatt 92/12**

(45) Bekanntmachung des Hinweises auf die
Patenterteilung :
**08.06.94 Patentblatt 94/23**

(84) Benannte Vertragsstaaten :
**CH DE ES FR GB IT LI NL SE**

(56) Entgegenhaltungen :
**DE-A- 2 030 688**
**DE-A- 3 615 487**

(73) Patentinhaber : **LEYBOLD**
**AKTIENGESELLSCHAFT**
**Wilhelm-Rohn-Strasse 25,**
**Postfach 1555**
**D-63450 Hanau (DE)**

(72) Erfinder : **Elvers, Björn**
**Alberndorfer Strasse 26**
**W-6452 Hainburg 2 (DE)**
Erfinder : **Rübsam, Klemens**
**Schulstrasse 16**
**W-6485 Jossgrund (DE)**
Erfinder : **Heinz, Jochen**
**Albert-Schweitzer-Strasse 5**
**W-6307 Linden-Leihgestern (DE)**
Erfinder : **Harwarth, Georg**
**Königsberger Strasse 11**
**W-8755 Alzenau (DE)**
Erfinder : **Reibold, Ulrich**
**Johann-Wilhelm-Strasse 75**
**W-6916 Wilhelmsfeld (DE)**
Erfinder : **Ross, Norbert**
**Hainstor 1**
**W-6457 Maintal 4 (DE)**

**Beschreibung**

Die Erfindung betrifft eine Vorrichtung zur laufenden Beschichtung von bandförmigen Substraten in einer Vakuumbeschichtungskammer mit einer Vielzahl von - eine Verdampferbank bildenden - Verdampferschiffchen etwa gleicher Größe und Konfiguration, wobei die Längsachsen der Schiffchen parallel zur Bandlaufrichtung und sämtliche Schiffchen nebeneinander in etwa gleichen Abständen angeordnet sind. Die Verdampferschiffchen sind sämtlich aus einer elektrisch leitenden Keramik gebildet und durch direkten Stromdurchgang beheizbar und es ist eine Vorrichtung für die kontinuierliche Zuführung von zu verdampfenden Draht zu den Verdampferschiffchen vorgesehen.

Zum Stand der Technik sind Vorrichtungen zur laufenden Beschichtung von bandförmigen Substraten in einer Vakuumbeschichtungskammer bekannt, bei denen die Verdampferschiffchen längs zur Bandlaufrichtung und parallel in etwa gleichen Abständen angeordnet sind.

Weiterhin ist eine Vorrichtung bekannt (DE-PS 970 246) die - um eine möglichst gleichmäßige Schichtstärke auf dem zu beschichtenden Substrat zu erreichen - den Verdampferschiffchen entsprechende Kammern in zwei oder mehr parallelen Reihen in derart versetzter Anordnung aufweist, so daß - von der Seite gesehen - sich die Kammern gegenseitig überdecken und keine Bedampfungslücke entsteht.

Darüberhinaus ist eine Vorrichtung zur kontinuierlichen Bedampfung von bandförmigen Substraten bekannt (FR-A 2 052 433), bei der als Verdampfer eine Vielzahl von Verdampferschiffchen vorgesehen sind, die senkrecht zur Bandlaufrichtung angeordnet sind und die kontinuierlich bewegt und mit Quellenmaterial ergänzt werden. Die Beheizung der Einzelschiffchen ist individuell regelbar. Ein Nachteil besteht unter anderem darin, daß diese Verdampferschiffchen nicht für die Verdampfung von in Drahtform zugeführten Metallen geeignet ist.

Schließlich ist eine Vorrichtung zur kontinuierlichen Bedampfung von bandförmigen Substraten bekannt (JA-A 01-219 157), bei der eine Vielzahl von Verdampferschiffchen mit gleichem Abstand zueinander und in Bandlaufrichtung angeordnet sind und die durch direkten Stromdurchgang beheizbar sind.

Diese vorstehend gekennzeichneten Vorrichtungen haben sämtlich den Nachteil, daß durch die Überlagerung der Verdampferkeulen der Einzelquellen eine ungleichmäßige Schichtverteilung auf dem zu beschichtenden Band entsteht. Im Idealfall ist dies eine wellenförmige Verteilung mit Maxima bzw. Minima über bzw. zwischen den Schiffchen. Die bestenfalls erreichbare Schichtgleichmäßigkeit wird bestimmt durch die Amplitude von Maxima und Minima. Die Amplitude selbst ist abhängig von der geometrischen Anordnung und der Emissions-Charakteristik (Ratenverteilung) der Einzelquellen sowie von der Wechselwirkung der Einzelquellen.

Die oben genannte Vorrichtung nach DE-PS 970 246 könnte möglicherweise die Schichtverteilung verbessern, hat aber den Nachteil, daß sie keinesfalls eine Alternative für eine Hochratenbeschichtung mit einer üblichen Beschichtungsrate von größer 1 µm/sec bei einer Bandbeschichtungsbreite von maximal 3 m darstellt, da

1. keine kontinuierliche Drahtzufuhr möglich und
2. die notwendige Energiezufuhr zum Verdampfen des Drahtes als technisch äußerst problematisch zu beurteilen ist.

Der Erfindung liegt deshalb die Aufgabe zugrunde, die gegenseitige Wechselwirkung der Einzelquellen zu verkleinern und damit die bislang erreichte Schichtgleichmäßigkeit zu verbessern, um ohne zusätzliche Kosten eine wesentlich verbesserte Beschichtungsqualität zu erreichen.

Diese Aufgabe wird erfindungsgemäß dadurch gelöst, daß die einzelnen Verdampferschiffchen der Verdampferbank jeweils zueinander versetzt angeordnet sind, wobei alle Verdampferschiffchen gemeinsam eine schmale Beschichtungszone überdecken, die sich quer zur Bandlaufrichtung erstreckt.

Vorzugsweise ist die Zugeführte elektrische Leistung für jedes Verdampferschiffchen individuell regelbar.

Durch diese Versetzung der Verdampferschiffchen reduziert sich die Zahl der Stöße von Dampfatomen untereinander (die freie Weglänge der Dampfatome liegt bei ca. 3 mm) und damit die gegenseitige Wechselwirkung. Dies wiederum bewirkt mit Vorteil eine nun flachere, wellenförmige Intensitätsverteilung mit Maxima bzw. Minima über bzw. zwischen den Schiffchen und somit eine bessere Gleichmäßigkeit der aufzudampfenden Schicht. Der Verlauf der Schicht läßt sich in einem Rechenmodell darstellen. Die flächigen Einzelquellen der Verdampferschiffchen entsprechen durch Überlagerung von Punktquellen einer allgemeinen Intensitätsverteilung proportional $\cos^n \beta$ ($\beta$ = Winkel zwischen der Flächennormalen des Schiffchens und dem Ortsvektor). Die gemessene Schichtdickenverteilung einer Einzelquelle (mit beispielsweise den Schiffchenabmessungen 10 x 30 x 150 (mm) und einer Kavität K von 25 x 90 (mm) läßt sich bei einer Beschichtungsrate von beispielsweise ca. 6 g/min durch eine Intensitätsverteilung mit einem Exponent $n = 4$ beschreiben. Bei der Schichtdickenverteilung einer gesamten Verdampferbank mit paralleler Schiffchenanordnung und mit einem Schiffchenabstand von beispielsweise $X = 95$ mm erhöht sich der Exponent auf $n = 20$, womit eine Erhöhung der Amplitude zwischen Maxima und Minima und damit eine schlechtere Schichtgleichmäßigkeit verbunden ist.

# Tab.1

| $a\,[mm]$ | $\dfrac{d_{max} - d_{min}\,[\%]}{d}$ | $(\eta_o - \eta)\,[\%]$ |
|---|---|---|
| 0 | 6 - 8 | 0 |
| 20 | 2 - 3 | 2 |
| 30 | < 1 | 4 |

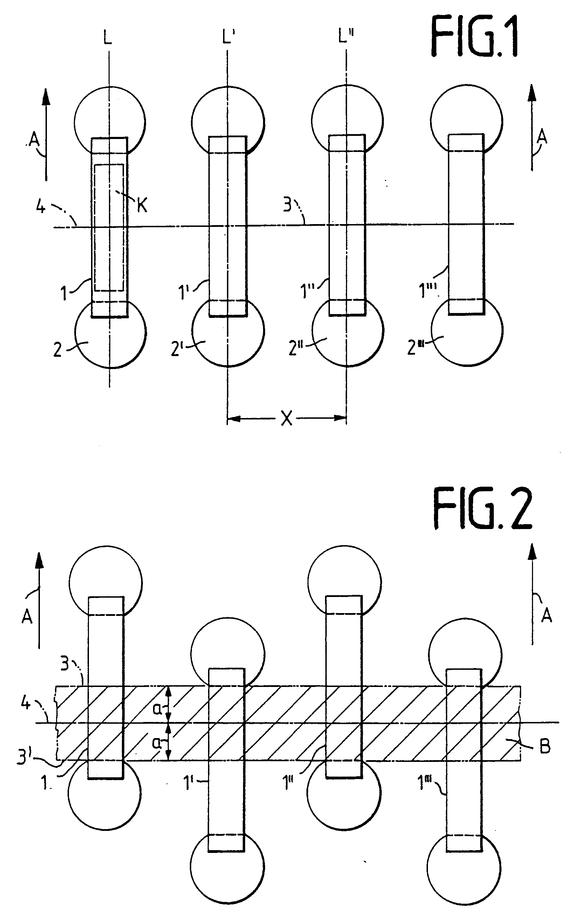

In Tabelle 1 sind als Funktion von a (a ist der Abstand zwischen den Querachsen 3, 3' der einzelnen Verdampferschiffchen 1, 1', ... und der Mittellinie 4 der Verdampferbank in Figur 2) die Schichtdickenschwankung

$$\frac{d_{max} - d_{min}}{d} \qquad (\%)$$

und der Wirkungsgradverlust $(\eta_o - \eta)$ (%) dargestellt.

$\eta$ ist der allgemeine Wirkungsgrad, der sich durch das Verhältnis der Mengen der auf das Substrat aufgedampften Moleküle zu den von den Verdampferschiffchen abgegebenen Molekülen ermittelt, und $\eta_o$ ist er Wirkungsgrad für a = 0. Dies vorausgesetzt und mit einer konstanten Abdampfrate von beispielsweise ca. 6 g/min wurde für a = 0, d.h. parallele Schiffchenanordnung, so wie sie bislang angewendet wurde, eine Schichtdickenschwankung von 6 - 8 % ohne Wirkungsgradverlust ermittelt. Für a = 20 mm wurde eine verminderte Schwankung der Schichtdicke von 2 - 3 % bei einem Wirkungsgradverlust von 2 % festgestellt. Bei einem Abstand a = 30 mm wurde eine Schichtdickenschwankung von kleiner/gleich 1 % festgestellt, wobei der Wirkungsgradverlust bereits 4 % betrug.

Der Wirkungsgradverlust läßt sich jedoch ausgleichen durch eine entsprechend erhöhte Aufdampfrate oder auch durch Geometrieänderungen an den Abschirmflächen.

Die Erfindung läßt die verschiedensten Ausführungsmöglichkeiten zu, eine davon ist in den anliegenden Zeichnungen näher dargestellt, und zwar zeigen:

Figur 1    schematische Darstellung von Verdampferschiffchen für die Al-Bandbeschichtung als Einzelquellen in paralleler Anordnung gemäß Stand der Technik in der Draufsicht,

Figur 2    schematische Darstellung von Verdampferschiffchen für die Al-Bandbeschichtung als Einzelquellen in versetzter Anordnung gemäß Erfindung in der Draufsicht,

Figur 3    eine Graphik zum Vergleich der Schichtdickenverteilung bei Schiffchenanordnung als separierte Einzelquelle und als Einzelquelle im Verbund.

Wie Figur 1 zeigt, weisen die rechteckförmigen Verdampferschiffchen 1, 1', ... auf ihren Oberflächen ebenso rechteckige Vertiefungen auf, die nachfolgend als Kavität K bezeichnet werden. An ihren Stirnseiten werden die Schiffchen 1, 1', ... von nahezu kreisrunden Einspannstücken 2, 2', ... gehalten und sind so angeordnet, daß ihre Längsachsen L, L', ... parallel und jeweils mit einem festen Abstand X zueinander verlaufen, wobei der Abstand X zwischen zwei benachbarten Verdampferschiffchen vorzugsweise zwei Drittel der Länge eines Verdampferschiffchens 1, 1', ... beträgt. Die gemeinsame Querachse 3 der einzelnen Verdampferschiffchen 1, 1', ... fällt mit der Mittellinie 4 aller Schiffchen 1, 1', ... und somit der gesamten Verdampferbank zusammen. Das zu beschichtende Band ist in Bandlaufrichtung A senkrecht zur Mittellinie 4 der Verdampferbank über diese hinweg bewegbar.

Figur 2 zeigt einen Ausschnitt aus einer Verdampferbank mit vier Verdampferschiffchen 1, 1', ... ähnlich der Darstellung in Figur 1. Figur 2 unterscheidet sich jedoch von Figur 1 darin, daß die Verdampferschiffchen 1, 1', ... mit ihren Querachsen 3, 3' um den Abstand a von der Mittellinie 4 der gesamten Verdampferbank wechselseitig versetzt sind, wobei jedoch alle Verdampferschiffchen 1, 1', ... gemeinsam eine schmale, schraffiert dargestellte Beschichtungszone B überdecken, die sich quer zur Bandlaufrichtung A erstreckt. Die Breite der Beschichtungszone B beträgt somit 2 x a und ist vorzugsweise kleiner als die halbe Länge eines Verdampferschiffchens 1, 1', ....

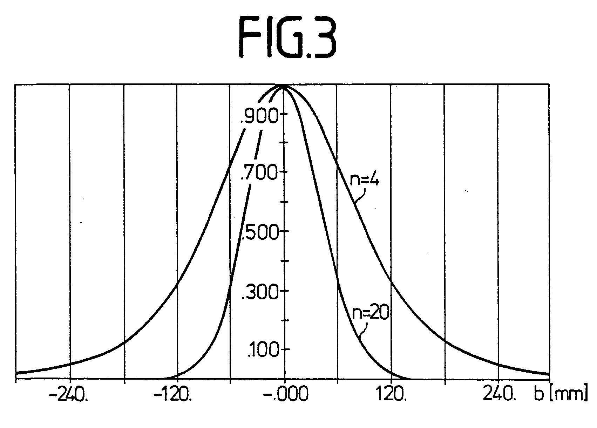

In Figur 3 ist eine graphische Darstellung der Schichtdickenverteilung auf einem beschichteten Bandsubstrat gezeigt. Die Verteilungskurven folgen einer cos-Funktion mit Exponent n, und zwar mit n = 4 für eine separierte Einzelquelle und mit n = 20 für eine Einzelquelle in einem Verbund.

Unabhängig von der absoluten Dicke der aufzubringenden Schicht haben die parabelförmigen Verteilungskurven ihr Maximum bei einem Abstand b = 0 mm senkrecht zur Längsachse L, L', ... des Verdampferschiffchens 1, 1', ..., d.h. das Maximum liegt auf der Längsachse L, L', ....

Die Verteilungskurve für die separierte Einzelquelle mit n = 4 schmiegt sich bei ca. ± 300 mm an die Ordinate b an, während die Kurve für eine Einzelquelle in einem Verbund von Verdampferschiffchen 1, 1', ... mit n = 20 einen sichtbar steileren Verlauf einnimmt und sich schon bei ca. ± 120 mm an die Ordinate b anlegt.

**Bezugszeichenliste**

| | |
|---|---|
| 1, 1', ... | Verdampferschiffchen |
| 2, 2', ... | Einspannstücke |
| 3, 3' | Querachse Verdampferschiffchen |
| 4 | Mittellinie Verdampferbank |
| K | Kavität |
| L, L', ... | Längsachse Verdampferschiffchen |
| X | Abstand Schiffchen zu Schiffchen |
| A | Bandlaufrichtung |
| B | Beschichtungszone |
| a | Abstand Querachse Verdampferschiffchen zu Mittellinie Verdampferbank |
| n | Exponent |
| b | Abstand senkrecht zur Längsachse des Verdampferschiffchens |
| d | mittlere Schichtdicke |
| $d_{max}$ | maximale Schichtdicke |
| $d_{min}$ | minimale Schichtdicke |
| η | Wirkungsgrad = |
| $η_o$ | Aufdampfrate/Abdampfrate Wirkungsgrad für a = 0 |

**Patentansprüche**

1.  Vorrichtung zur laufenden Beschichtung von bandförmigen Substraten in einer Vakuumbeschichtungskammer, mit einer Vielzahl von - eine Verdampferbank bildenden - Verdampferschiffchen (1, 1', ...) etwa gleicher Größe und Konfiguration, wobei die Längsachsen der Schiffchen (1, 1', ..) parallel zur Bandlaufrichtung (A) und sämtliche Schiffchen (1, 1', ...) nebeneinander in etwa gleichen Abständen (X) angeordnet sind und die Verdampferschiffchen (1, 1', ...) sämtlich aus einer elektrisch leitenden Keramik gebildet und durch direkten Stromdurchgang beheizbar sind und wobei eine Vorrichtung für die kontinuierliche Zuführung von zu verdampfenden Draht zu den Verdampferschiffchen vorgesehen ist, **dadurch gekennzeichnet,** daß die einzelnen Verdampferschiffchen (1, 1', ...) der Verdampferbank jeweils zueinander versetzt angeordnet sind, wobei alle Verdampferschiffchen (1, 1', ...) gemeinsam eine schmale Beschichtungszone (B) überdecken, die sich quer zur Bandlaufrichtung (A) erstreckt.

2.  Vorrichtung nach Anspruch 1, **dadurch gekennzeichnet,** daß die zugeführte elektrische Leistung für jedes Verdampferschiffchen (1, 1', ...) individuell regelbar ist.

**Claims**

1.  Apparatus for the continuous coating of substrates in the form of a strip in a vacuum coating chamber, having a plurality of vaporiser shuttles (1, 1', ...) - forming a vaporiser bank - of approximately the same size and configuration, wherein the longitudinal axes of the shuttles (1, 1', ...) are arranged parallel to the direction of travel (A) of the strip and all the shuttles (1, 1', ...) are arranged next to one another at approximately equal intervals (X) and the vaporiser shuttles (1, 1', ...) are all made from an electrically conductive ceramic material and are heatable by having a current passed directly through them, and wherein a device is provided for continuously supplying wire to be vaporised to the vaporiser shuttles, characterised in that the individual vaporiser shuttles (1, 1', ...) of the vaporiser bank are all staggered relative to one another, so that all the vaporiser shuttles (1, 1', ...) together cover a narrow coating zone (B) extending transverse to the direction of travel (A) of the strip.

2. Apparatus according to claim 1, characterised in that the electric power supplied for each vaporiser shuttle (1, 1', ...) is individually adjustable.

**Revendications**

1. Dispositif pour le revêtement en continu de substrats en forme de bande dans une chambre de revêtement sous vide, comprenant une pluralité de cuvettes de vaporisation (1, 1', ...), qui forment un banc de vaporisation, ayant approximativement la même taille et la même configuration, les axes longitudinaux des cuvettes (1, 1', ...) s'étendant parallèlement à la direction de progression de la bande (A), et toutes les cuvettes (1, 1', ...) étant agencées les unes à côté des autres approximativement à la même distance (X), et les cuvettes de vaporisation (1, 1', ...) étant toutes formées en une céramique conductrice de l'électricité et pouvant être chauffées par passage direct de courant, et un dispositif étant prévu pour alimenter en continu dans les cuvettes de vaporisation du fil à vaporiser, caractérisé en ce que les cuvettes de vaporisation individuelles (1, 1', ...) du banc de vaporisation sont agencées de manière décalée respectivement les unes par rapport aux autres, toutes les cuvettes de vaporisation (1, 1', ...) couvrant conjointement une zone étroite de revêtement (B), qui s'étend perpendiculairement à la direction de progression de la bande (A).

2. Dispositif selon la revendication 1, caractérisé en ce que la puissance électrique admise est réglable individuellement pour chaque cuvette de vaporisation (1, 1', ...).

# FIG.1

# FIG.2

# FIG.3